Europäisches Patentamt

European Patent Office

Office européen des brevets

(11) Publication number: **0 255 782**
**A2**

## (12) EUROPEAN PATENT APPLICATION

(21) Application number: **87306786.2**

(22) Date of filing: **30.07.87**

(51) Int. Cl.⁴: **H 01 L 29/72**
**H 01 L 29/08**

(30) Priority: **01.08.86 US 893118**

(43) Date of publication of application:
**10.02.88 Bulletin 88/06**

(84) Designated Contracting States:
**BE DE FR GB IT NL**

(71) Applicant: **SILICONIX incorporated**
**2201 Laurelwood Road**
**Santa Clara California 95054 (US)**

(72) Inventor: **Cogan, Adrian I.**
**1174 Hyde Avenue**
**San Jose California 95129 (US)**

**Severns, Rudolf P.**
**11832 Timmy Lane**
**Garden Grove California 92640 (US)**

(74) Representative: **Jones, Ian et al**
**POLLAK MERCER & TENCH High Holborn House 52-54**
**High Holborn**
**London WC1V 6RY (GB)**

The title of the invention has been amended (Guidelines for Examination in the EPO, A-III, 7.3).

(54) Insulated gate bipolar-mode field effect transistor.

(57) An insulated gate bipolar transistor (IGBT) device incorporates a base contact (40a,40b) usable with an external circuit for depleting charge from the base (18) when stopping bipolar conduction, thereby increasing turn-off speed. Fabrication of the IGBT is described.

FIG.—3a.

**Description**

INSULATED GATE BIPOLAR OR TRIPOLAR DEVICE

This invention relates to semiconductor devices, and more specifically to an insulated gate bipolar transistor (IGBT) device.

An IGBT structure merges a vertical double diffused metal oxide semiconductor (DMOS) field effect transistor (FET) with a wide base bipolar transistor, to combine the advantages of MOS gate control with bipolar low on-resistance in a conductivity modulated structure. A logic signal applied to the gate lead of an IGBT controls conduction of a large current from an anode lead to a cathode lead of the IGBT.

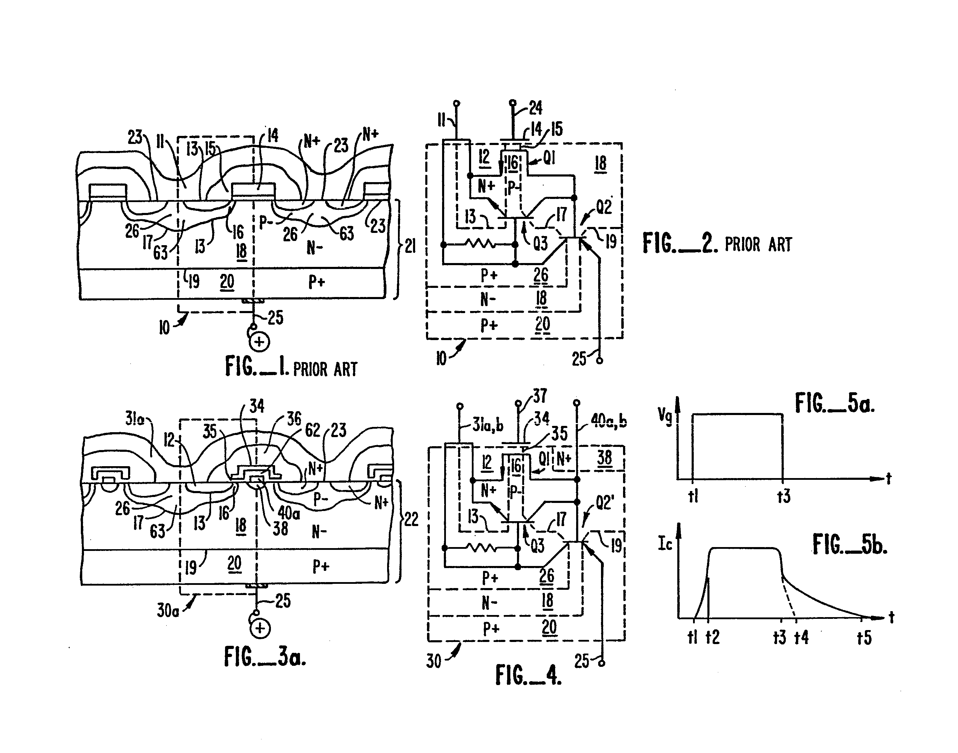

In a prior art IGBT cell 10, as illustrated by the cross section of Fig. 1 of the accompanying drawings, and by the circuit diagram of Fig. 2, a P+ semiconductor wafer 20 functions as emitter 20 of bipolar transistor Q2. The wafer 20 initial upper planar surface 19 supports, and forms an emitter-base junction 19 with, an N-type epitaxial layer 18. The epitaxial layer 18 functions both as base 18 of bipolar transistor Q2 and as drain 18 of DMOS transistor Q1. A P type body region 26, beneath upper surface 23 of epitaxial layer 18, provides both a conduction channel 16 for DMOS transistor Q1, and a collector 26 for bipolar transistor Q2. Beneath epitaxial surface 23 and within body region 26, a smaller N+ type diffusion well 12 functions as source 12 of DMOS transistor Q1. On surface 23 over channel 16 between source well 12 and upper epitaxial layer 18, insulation layer 15 supports polycrystalline silicon gate electrode 14. Remote from gate 14, body region 26 typically increases in depth and conductivity in a deep body region 63 providing a low resistance path to divert collector 26 current from flowing along, and forward biasing, source-body junction 13. If junction 13 becomes sufficiently forward biased, then a parasitic second bipolar transistor Q3, formed by N+, P, and N-type regions 12, 26, and 18, respectively, starts conducting and latches four layer thyristor-like structure 10 into conduction. Processes for fabricating a prior art IGBT 10 are well known in the art, as exemplified in U.S. Patent No. 4,443,931.

When an appropriate bias Vg, for example, one to five volts positive with respect to cathode lead 11 (Figs. 1 and 2), is applied to gate 14 at time t1 (Fig. 5a). DMOS transistor Q1 rapidly turns on and conducts electrons from cathode lead 11 through source 12 and channel 16 to drain 18, thereby supplying current to charge base 18 of, and to turn on, bipolar transistor Q2. After typically 100 to 1,000 nanoseconds transistor Q2 completes turning on at time t2 (Fig. 5b), and conducts a high density current through the low resistance path from anode lead 25 to cathode lead 11.

Although DMOS transistor Q1 supplying base 18 current assists turning on bipolar transistor Q2, DMOS transistor Q1 does not assist turning off bipolar transistor Q2. When the externally provided control voltage Vg is lowered on gate 14 at time t3 (Fig. 5a) in order to turn off DMOS transistor Q1 channel 16 current and thus turn off bipolar transistor Q2 base current, charge remains trapped in base 18. The capacitance of base 18 is relatively large due to the need for a large epitaxial layer 18 to accommodate a depletion layer widening downward from reverse biased junction 17, for high voltage operation without breaking down. With no direct contact to an external lead, base 18 "floats" and delays bipolar transistor Q2 from switching off during the relatively long 500 nsec to 5 $\mu$sec interval until time t5 (Fig. 5b), while charge carriers (holes) in base 18 recombine or drift, in an exponentially decaying current, across junction 17 to flow through collector 16 and out cathode lead 11. Hence, turn-off time interval t5-t3 typically exceeds turn-on interval t2-t1 by at least an order of magnitude, during which time IGBT 10 continues to conduct, and power is undesireably dissipated as heat.

In some prior art IGBT devices, as described for example by B. J. Baliga in "Switching Speed Enhancement in Insulated Gate Transistors by Electron Irradiation," IEEE Transactions on Electron Devices, Vol. Ed. 31 pp. 1790-1795 (1984), to increase turn-off speed, base discharge is facilitated by controlling charge carrier lifetimes through doping base region 18 with gold, or through electron or neutron irradiation. However, such doping increases base resistance and power dissipation.

The present invention provides an IGBT semiconductor device with a structure for increasing turn-off speed, and a process for making such a structure.

An IGBT according to the invention incorporates a base contact useful with an external circuit for depleting charge from the base when stopping bipolar conduction. Spaced laterally from a channel body region in an epitaxial layer which provides the base, an epitaxial layer surface forms a base contact with an overlying metal or other conductive lead. In an IGBT device where multiple cells share a common base region, base contacts are spaced midway between channel body regions, and to minimise ohmic series resistance, a base contact is preferably provided between each pair of cells. In one embodiment, a refractory metal is used to form base contacts with leads beneath the gate electrode layer, and in an alternate embodiment another common contact lead material such as aluminium or polycrystalline silicon is used to form base contacts with base leads extending between gate electrodes. Base contact resistance is preferably further reduced by providing a shallow N+ base contact well in the epitaxial layer beneath each surface area forming a base contact.

The invention is further described, by way of example, with reference to the further figures of the accompanying drawings, in which:

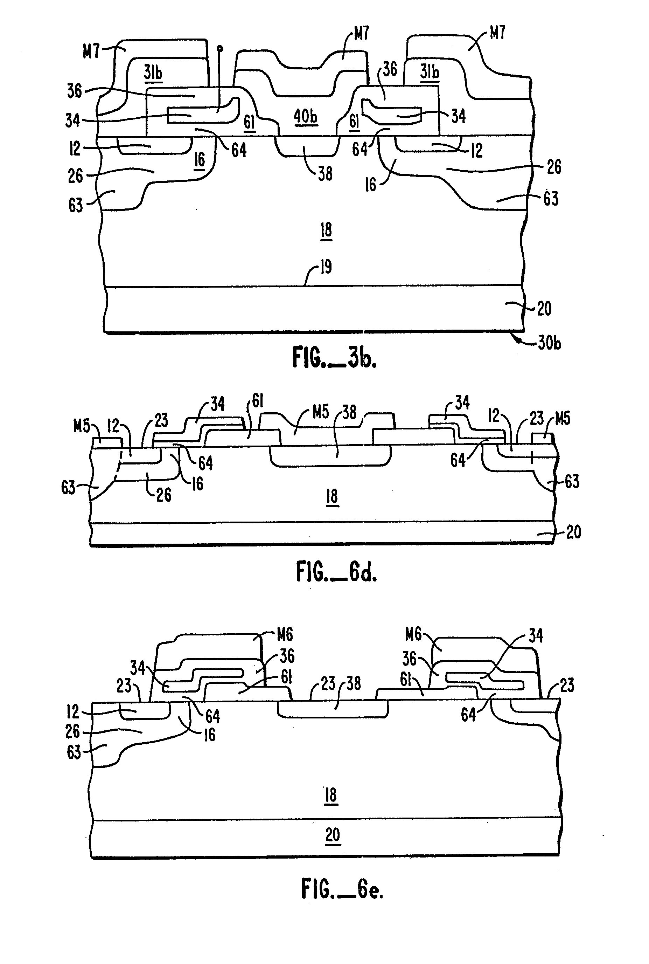

Figs. 3a and 3b are cross sections of IGBT cells in first and second embodiments of the invention;

Fig. 4 is a circuit schematic of an IGBT cell according to the invention;

Fig. 5a is a graph of a control voltage pulse applied during interval t1 to t3 to the gate of an IGBT cell as in Fig. 1 or Fig. 3;

Fig. 5b is a graph showing the delay from the control pulse voltage drop in Fig. 5a at time t3 until a conventional IGBT turns off at time t5, compared to the shorter delay until the IGBT of this invention turns off at time t4;

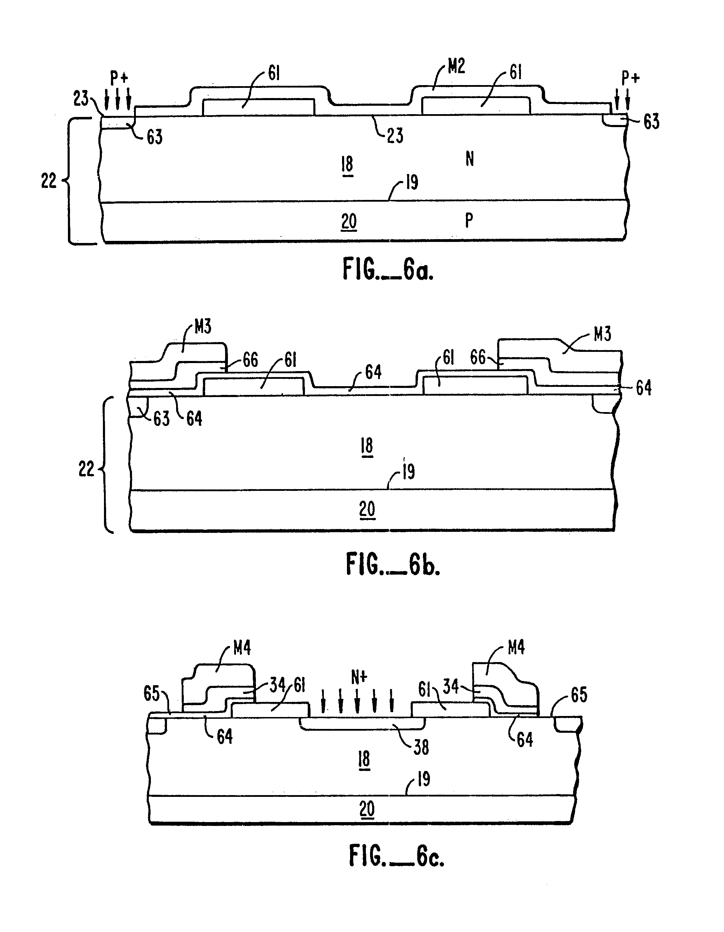

Figs. 6a to 6e are cross sections showing steps in the formation of an IGBT cell with a structure as in Fig. 3b;

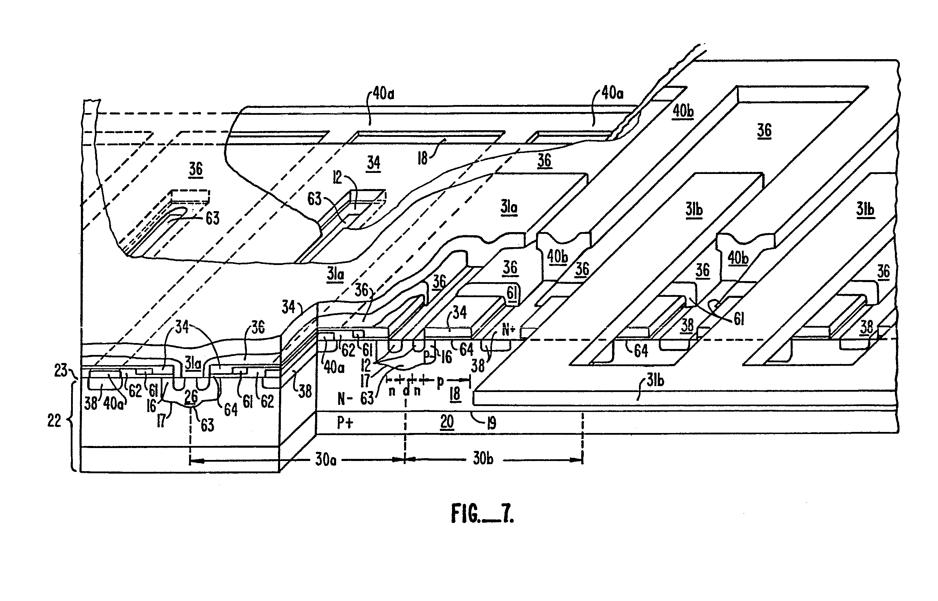

Fig. 7 is an isometric cutaway view of the IGBT cells of Figs. 3 and 3b juxtaposed for the sake of illustration; and

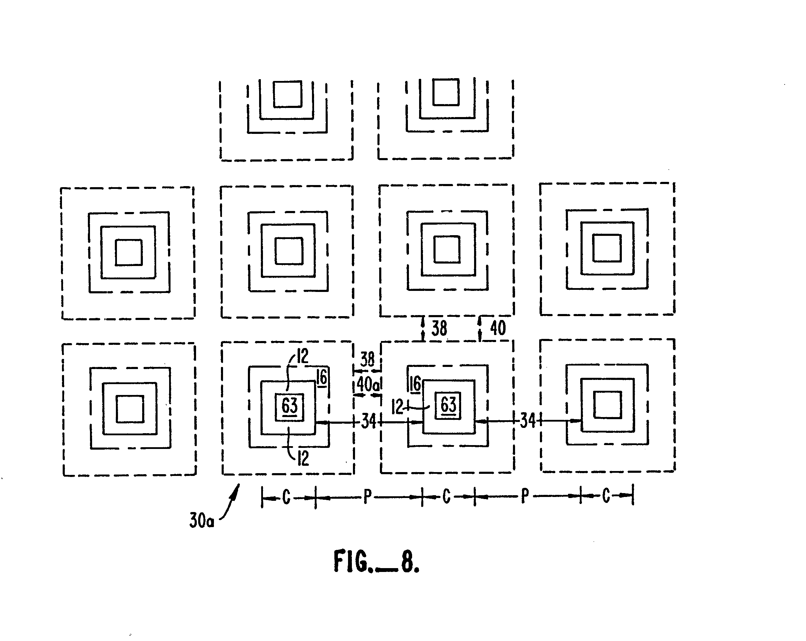

Fig. 8 is a top view of a layout for the cell of Fig. 3a in another embodiment.

The present invention, in a first embodiment as cell 30a in Fig. 3a and in a second embodiment as cell 30b in Fig. 3b, provides an insulated gate bipolar transistor cell structure with a base contact useful for discharging the bipolar base region to help stop bipolar conduction when turning off the IGBT device. Cells 30a and 30b are both represented by the equivalent circuit schematic of cell 30 in Fig. 4.

In operation, when cathode lead 31a,b (Fig. 3a, Fig. 3b) is biased negatively with respect to gate lead 37, (Fig. 4) and gate lead 37 is biased negatively with respect to anode lead 25, N channel DMOS transistor Q1 channel 16 conducts current from drain/base 18, bipolar transistor Q2′ emitter-base junction 19 is forward biased, and current flows from anode lead 25 through P+ emitter region 20 and across junction 19 into N-base region 18, where holes become minority carriers and provide body region 16 with channel current for DMOSFET Q1 and collector current to cathode lead 31a,b.

IGBT 30 is turned off for example by shorting gate lead 37 to cathode lead 31a,b at time t3 (Figs. 5a,b), eliminating the channel 16 current which had been forward biasing N- base 18 negative with respect to P+ emitter 20. However, base 18 remains charged with holes, which, without base current forward biasing junction 19, represent a net positive charge with respect to P+ region 20, and gradually drift across reverse biased junction 17 to continue providing a cathode current.

In accordance with the teachings of this invention, newly provided base lead 40a or 40b is used to discharge base 18 through well-known types of external circuits, thereby stopping cathode lead 31a,b current sooner. The external circuit can be a switch, not shown, which closes when IGBT 30a,b is being turned off, such as a PMOS enhancement mode transistor having a source lead connected to base lead 40a,b, a drain lead connected to anode lead 25, and a gate lead connected to, or at least biased simultaneously with gate lead 37 of, to switch opposite, N- channel DMOS transistor Q1. This provides a low impedance path through which the base 18 stored positive charge (holes) will be shorted back to anode lead 25 and emitter region 20, thereby diverting collector current so that the new IGBT 30a,b turns off faster, typically reducing the delay from time t3 to transistor Q2 turn-off at time t4, to within one-tenth of the delay until time t5 required to turn off a conventional IGBT 10, Fig. 1, lacking a base contact.

An IGBT device with base contacts is preferably fabricated in a process, referring to Fig. 6a, beginning with a P+ type conductivity semiconductor wafer 20 of which the initial upper planar surface 19 supports an epitaxially grown N type layer 18. Wafer 20 and epitaxial layer 18 together comprise substrate 22. After preparation, epitaxial layer 18 top surface 23 is thermally oxidized to form a 15,000Å thick oxide layer. The thick oxide layer is then covered with photoresist, which is then patterned to form a first mask, not shown, protecting the thick oxide layer in portions for base contact isolation barriers 61, Fig. 6a, while unprotected areas of the thick oxide layer are etched away, by well known techniques. The first mask is removed and replaced with photoresist implant block mask M2, Fig. 6a, exposing substrate surface 23 in areas which are then implanted with P type ions such as boron to form deep body regions 63. Afterwards, implant block mask M2 is removed.

Referring to Fig. 6b, the existing top surface is then oxidized to form 1000Å gate oxide layer 64, which in turn is covered with $Si_3N_4$ forming a 1400Å layer including portions 66. Over nitride layer 66, a layer of photoresist is deposited and patterned as third mask M3. A well-known dry (e.g., plasma, RIE) or wet (e.g., $H_3PO_4$) etch is used to etch the nitride layer, leaving ion implant mask 66 protecting gate oxide 64 over to-be-formed body regions 26 (Fig. 6d), while gate oxide 64 is etched from surface 23 in areas reserved for base contacts 40a or 40b (Fig. 3a or 3b), between base contact isolation barriers 61. Photoresist mask M3 is then removed. Next, base contact area resistance is preferably reduced by implanting N type ions, e.g. arsenic at an energy of 60 KEV and a dosage of 1 to $5 \times 10^{15}$ atoms/cm², to form base contact well 38, Fig. 6c. $Si_3N_4$ implant mask 66 is then removed.

Following this stage, cell 30a, Fig. 3a and the left side of Fig. 7, is formed by using well known techniques of depositing a refractory metal (e.g., tungsten, molybdenum, cobalt) in a layer for base contacts 40a, masking and etching the metal layer to leave a network of base contact leads 40a. Leads 40a are then covered with oxide or other insulation 62. Thus, base contact leads 40a are formed before and beneath gate layer 34. Cell 30a is completed as follows, except that metal 40a and insulation 62 have already been formed and are not shown in Figs. 6c through 6e, which illustrate cell 30b.

Next, structure 30a or 30b is covered with a polycrystalline silicon layer, over which photoresist is deposited and patterned for fourth mask M4. The polycrystalline silicon layer, where exposed, is etched to leave gate electrodes 34 as shown in Fig. 6c. Fourth mask M4 is then removed. Areas of gate oxide 64 which were protected under implant mask 66, but which are not now protected under a gate electrode 34 (i.e., oxide 64 in areas 65 over to-be-formed P type body regions 26 and between gate electrodes 34), are then removed in a well known manner.

Photoresist is applied and patterned to form an implant mask M5, Fig. 6d, over base contact wells 38 and over deep body regions 63, while exposing surface 23 in areas for channel body 26. Mask M5 exposes areas both for implantation with P type ions, preferably boron at an energy of 60 KEV to a dosage of $1 \times 10^{14}$ atoms/cm$^2$, and for implantation with N type ions, preferably arsenic at an energy of 60 KEV to a dosage of $5 \times 10^{15}$ atoms/cm$^2$. Mask M5 is then stripped, and the device is heated to 1100°C for 100 to 500 minutes to diffuse the P and N type atoms to form channel body 26 and emitter 12 regions, respectively, as shown in Figs. 6d and 7.

The existing upper surface is again covered with oxide in a layer including oxide 36, over which sixth photoresist mask M6 is formed to protect oxide 36 over and around polycrystalline silicon gate electrodes 34, Fig. 6e, while unprotected oxide is etched to expose surface 23 areas over channel body 26 and emitter 12 for formation of cathode contacts 31a or 31b, and also to expose areas in embodiment 30b for interdigitated base contacts 40b. Oxide 36 may also be etched to form windows exposing areas not shown in gate layer 34 for gate leads 37 (Fig. 4). Sixth mask M6 is then removed.

A conductive metallization layer is formed over the existing top surface, followed by a layer of photoresist, which is patterned to form seventh mask M7 protecting the metal layer in cell 30a for cathode leads 31a, or in cell 30b for separate cathode leads 31b and base leads 40b, which may be interdigitated as shown in Fig. 7, while uncovered metal is etched away, after which mask M7 is removed.

Finally, a passivation layer of for example silicon dioxide or silicon nitride is deposited, not shown, over the entire device to protect it from its environment, and the conductor lead contact pads are connected through thin wires to external circuitry (not shown).

An embodiment of cells 30a is laid out in a device for example as shown in the top view of Fig. 8. Omitting details, cells 30a are formed by body 26 regions 63 and 16, and source regions 12, in concentric squares surrounded, and separated, by gate electrodes 34.

Fig. 7 shows embodiments of cells 30a on the left and 30b on the right, juxtaposed on a common substrate 22 for the sake of illustration, although in practice an IGBT device typically would not include both embodiments. Cathode contact 31a,b lateral dimension on surface 23 $C = d + 2n = 15 \pm 5$ μm equals dimension C in the Fig. 8 embodiment. However, in the Fig. 7 embodiment, the gate 34 lateral dimension P is increased to 40 μm, and the entire device 30a or 30b dimension normal to the plane of the Fig. 7 cross-section is increased to make longer cathode contacts 31a,b and thus wider channels 16.

Preferred embodiments have been illustrated, of which modifications and adaptations within the scope of the invention will occur to those skilled in the art.

## Claims

1. An insulated gate bipolar transistor (IGBT) device comprising a first conductivity type semiconductor wafer, a second conductivity type epitaxial base layer on the wafer and having an upper planar surface, a first conductivity type body region beneath the upper surface in the epitaxial layer, a second conductivity type emitter well region beneath the upper surface and within the body region, a layer of insulation on the upper surface over part of the body region defining a channel beneath the insulation, and a gate electrode on the insulation layer, characterised by a conductive layer patterned to form a base lead contact on a surface of the epitaxial layer isolated from the body region and from the gate electrode.

2. An IGBT device as claimed in claim 1 characterised in that the epitaxial layer has a higher concentration second conductivity base well beneath the upper surface at the base contact.

3. An IGBT device as claimed in claim 1 or 2 characterised in that the conductive layer is patterned to form also a distinct cathode lead contact to the upper surface over the body and emitter regions.

4. An insulated gate bipolar transistor (IGBT) device comprising a first conductivity type semiconductor wafer supporting a second conductivity type epitaxial layer having an upper surface beneath which first conductivity type body regions penetrates in selected areas, characterised by a base contact to the upper surface of the epitaxial layer spaced from the body regions.

5. A circuit comprising an insulated gate bipolar transistor (IGBT) device having anode, cathode, gate, and base leads, characterised by means for controllably connecting the base lead to the anode lead.

6. The use of the circuit claimed in claim 5 to control conduction of current between first and second potential current leads, characterised by the steps of connecting the anode and cathode leads each to a respective current lead, at one time applying to the gate lead a potential between the first and second potentials so that the circuit conducts current from the anode lead to the cathode lead, and at another time applying to the base lead a potential equal to the potential of the anode lead sop that the circuit stops conducting current from the cathode lead.

7. A process of forming an insulated gate bipolar transistor (IGBT) device with a bipolar base region provided by an epitaxial layer supported on a semiconductor wafer, characterised by the step of forming a conductive lead contact to the surface of the epitaxial layer providing the base region.

8. A process as claimed in claim 7 characterised by the step of increasing the conductivity of the epitaxial layer beneath the surface in the contact.

9. A process of forming an insulated gate bipolar transistor (IGBT) device from a semiconductor substrate comprising a first conductivity type wafer supporting a second conductivity type epitaxial layer, characterised by the steps of forming a pair of barriers separated by an epitaxial layer contact surface area beneath which the epitaxial layer is continuously second conductivity type through to the wafer and depositing conductive lead material to form a base contact with the epitaxial layer surface within the contact area between the barriers.

10. A process as claimed in claim 9 characterised in that the conductive lead material is a refractory metal.

FIG._2. PRIOR ART

FIG._4.

FIG._1. PRIOR ART

FIG._3a.

FIG._5a.

FIG._5b.

0255782

FIG._3b.

FIG._6d.

FIG._6e.

0255782

FIG.\_6a.

FIG.\_6b.

FIG.\_6c.

0255782

FIG._7.

0255782

FIG.—8.